# EUROPEAN PATENT SPECIFICATION

(11) **EP 1 548 474 B1**
(45) Date of publication and mention of the grant of the patent: **27.06.2007**
(21) Application number: 04029997.6
(22) Date of filing: 17.12.2004
(51) Int. Cl.: G02B 6/42

(54) **Optical device for detecting an optical signal and method of manufacturing the same**
Optische Vorrichtung zur Erfassung eines optischen Signales und deren Herstellungsverfahren
Dispositif optique pour la détection d'un signal optique et sa méthode de fabrication

(30) Priority: 17.12.2003 KR 2003092504
(43) Date of publication of application: 29.06.2005
(73) Proprietor: SAMSUNG ELECTRONICS CO., LTD., Suwon-city, Gyeonggi-do (KR)
(72) Inventor: Hwang, Seong-mo, Yeongtong-gu Suwon-si Gyeonggi-do (KR); Kim, Young-hun, Gyeonggi-do (KR); Nam, Seung-ho, Seongnam-si Gyeonggi-do (KR); Kim, Young-chan, Suwon-si Gyeonggi-do (KR)
(74) Representative: Grünecker, Kinkeldey, Stockmair & Schwanhäusser Anwaltssozietät

(56) References cited:
- EP-A- 0 281 989
- US-A- 5 193 131
- US-A- 5 917 981
- US-A1- 2003 207 127
- PRESTING H: "Near and mid infrared silicon/germanium based photodetection" PREPARATION AND CHARACTERIZATION, ELSEVIER SEQUOIA, NL, vol. 321, no. 1-2, 26 May 1998 (1998-05-26), pages 186-195, XP004147918 ISSN: 0040-6090

## Description

The present invention relates to an optical device, and more particularly, to an optical device including integrally an optical waveguide for guiding light and an optical detector for detecting the light, and a method of manufacturing the same.

Recently, an optical communication network, which connects optical fibers to subscriber's terminals, has been actively studied by many institutes so as to embody a high speed optical communication network. In addition, optical communication subscriber test networks have been established and run in some regions so as to widely spread the optical communication.

An optical transceiver is essential to establish such an optical communication network. The optical transceiver converts a digitalized electrical signal into an optical signal within a predetermined wavelength band, transmits the optical signal through an optical fiber, detects the optical signal within the arbitrary wavelength band received through the optical fiber, and converts the optical signal into a digitalized electrical signal back.

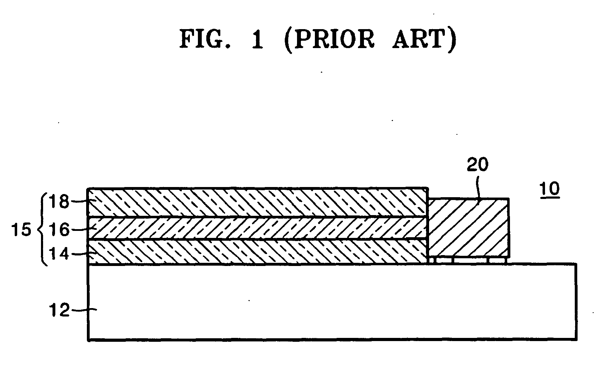

FIG. 1 is a cross-sectional view of a conventional optical device including integrally an optical waveguide and an optical detector as portions of a receiver section of the optical transceiver.

Referring to FIG. 1, the conventional optical device 10 having the optical waveguide and the optical detector includes a silicon substrate 12, an optical waveguide 15 and an optical detector 20 made of InGaAs. The optical waveguide 15 includes a first clad layer 14 made of SiO₂, a core layer 16 made of SiO₂:Ge and a second clad layer 18 made of SiO₂. The first clad layer 14, the core layer 16 and the second clad layer 18 are formed sequentially on a predetermined region of the silicon substrate 12.

The conventional optical device 10 is manufactured in a hybrid integration method in which the optical detector 20 is finely adhered on a predetermined position of a silicon substrate 12 having the optical waveguide 15 thereon using flip-chip bonding technique.

The hybrid integration method, however, makes the entire manufacture processes complex and lowers a production yield because of misalignment of core layers of an optical waveguide and an optical detector.

As a consequence, since a lot of time and efforts are required to finely align to partially solve the above problems and expensive equipment is also necessary, it is limited to lower the price.

Furthermore, the separately manufactured optical detector is manufactured using compound semiconductor suitable for a mainly used wavelength band. The substrate employed in the optical detector is not only expensive but also impossible to lower its production cost due to the limitation of mass production based on a large diameter of wafer.

US 5,193,131 discloses an optoelectronic device with an integrated optical guide and photo detector. This device comprises a partial reflecting layer inserted in the lower confinement layer and the guide layer. In the integrated device according to US 5,193, the light absorbance is not optimized. EP 0 281 989 discloses a channel waveguide Schottky photodiode comprising a silicon dioxide covered substrate of gallium arsenide, a thin film waveguide of zinc oxide having a thickened rib to delineate the waveguide path and an opening or thin portion provided on the silicon dioxide before deposition of the zinc oxide so that the ribbed area of the zinc oxide makes direct contact with the gallium arsenide. On either side of the direct contact, a metal electrode is in contact with the gallium arsenide forming a narrowly spaced Schottky diode.

It is, therefore, the object of the present invention to provide an optical device with better light absorption properties.

This object is solved with the optical device according to claim 1 and the method according to claim 12. Preferred embodiments are according to the dependent claims.

The present invention provides an optical device including integrally an optical waveguide and an optical detector, and a method of manufacturing the same.

According to an aspect of the present invention, there is provided an optical device including: a substrate; a first single crystalline growth layer grown on the substrate; an optical waveguide provided with a clad layer and a core layer formed on the first single crystalline growth layer; an undoped layer formed on a predetermined portion of the core layer where a portion of the clad layer has been removed so as to absorb light that travels along the optical waveguide and is within a predetermined wavelength band; a second single crystalline growth layer grown on the undoped layer; an n-type electrode formed on a side of the substrate; and a p-type electrode connected electrically to the second single crystalline growth layer.

According to another aspect of the present invention, there is provided an optical device for detecting an optical signal within a predetermined wavelength band including: an optical waveguide provided with a clad layer and a core layer, for guiding the optical signal; and an optical detector including a light absorption region, for detecting the optical signal, wherein the light absorption region of the optical detector is adjacent to the core layer of the optical waveguide.

According to another aspect of the present invention, there is provided a method of manufacturing an optical device for detecting an optical signal, including: growing a first single crystalline growth layer on a substrate; forming a first clad layer on the first single crystalline growth layer; patterning the first clad layer so as to make the first clad layer slant; forming a core layer on the patterned first clad layer and the single exposed crystalline growth layer; forming a second clad layer on the core layer; exposing a predetermined region of the core layer by patterning the second clad layer in a predetermined shape; and forming a second single crystalline growth layer on the exposed core layer.

If the substrate is made of silicon, the first single crystalline growth layer and the second single crystalline growth layer may be silicon germanium layers.

The silicon germanium layer may be made of silicon germanium compound (SiₓGe₁₋ₓ), where x goes from 1 to 0 gradually as it goes far from the substrate so that a portion near to the exposed core layer of the optical waveguide includes any one selected from the group consisting of silicon germanium compound whose germanium ratio is high (0 ≤ x ≤ 0.4) and pure germanium (x = 0).

The portion made of any one selected from the group consisting of silicon germanium compound whose germanium ratio is high (0 ≤ x ≤ 0.4) and pure germanium (x = 0) may be the light absorption region.

If the substrate is made of InP, the single crystalline growth layers may be made of InₓGa₁₋ₓAs to form the light absorption region.

Refractive index difference between the core layer and the clad layer may be so large that a cross-sectional area of a core is allowed to be small.

The core layer is made of silicon nitride, and the clad layer is made of silicon dioxide.

An n-type electrode may be formed on a side of the substrate and a p-type electrode may be formed on the second single crystalline growth layer.

The optical device further includes an insulating layer under a portion where the optical detector is formed near to the exposed core layer of the first single crystalline growth layer.

The above and other features and advantages of the present invention will become more apparent by describing in detail exemplary embodiments thereof with reference to the attached drawings in which:
FIG. 1 is a cross-sectional view of a device including an optical waveguide and an optical detector embodied in a hybrid integration method according to the related art;
FIG. 2 is a cross-sectional view of an optical device including an optical waveguide and an optical detector integrally embodied according to a preferred embodiment of the present invention;
FIG. 3 is a cross-sectional view of an optical device taken along the line A-A' in FIG. 2;
FIGS. 4A through 4H are cross-sectional views to illustrate a method of manufacturing an optical device including an optical waveguide and an optical detector integrally embodied according to a preferred embodiment of the present invention;
FIG. 5 is a cross-sectional view of an optical device including an optical waveguide and an optical detector integrally embodied according to an example not according to the present invention;
FIG. 6 is a cross-sectional view of an optical device taken along the line B-B' in FIG. 5; and
FIGS. 7A through 7B are graphs to illustrate a simulation result representing the amount of light absorbed by the optical detector from the optical waveguide in the optical device including the optical waveguide and the optical detector integrally.

Hereinafter, the present invention will be described in detail by explaining preferred embodiments of an optical device including integrally an optical waveguide and an optical detector, and a method of manufacturing the same according to the present invention with reference to the attached drawings. Like reference numerals in the drawings denote like elements.

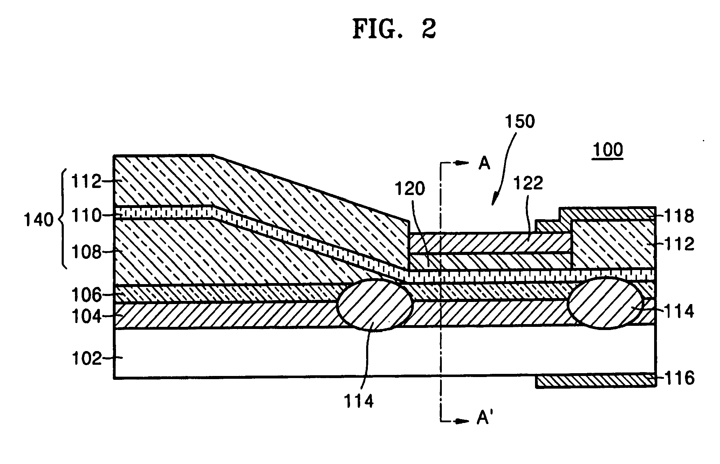

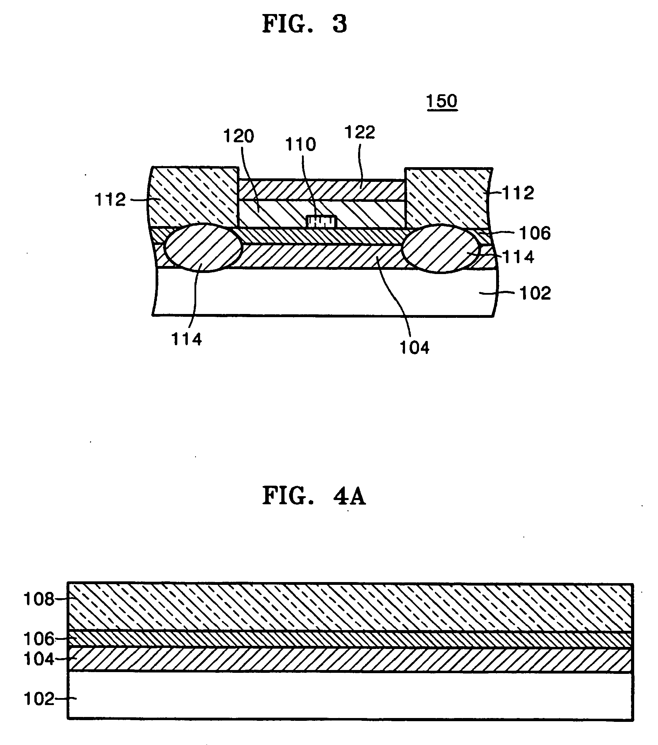

FIG. 2 is a cross-sectional view of an optical device including an optical waveguide and an optical detector integrally embodied according to a preferred embodiment of the present invention. FIG. 3 is a cross-sectional view of an optical device taken along the line A-A' in FIG. 2.

Referring to FIGS. 2 and 3, an optical device 100 according to an embodiment of the present invention includes an optical waveguide 140 provided with first and second clad layers 108 and 112 and a core layer 110, and an optical detector 150 provided with a first silicon germanium layer 104 (first crystalline growth layer), a first undoped layer 106 (additional undoped layer), a second undoped layer 120 and a second silicon germanium layer 122 (second crystalline growth layer).

The first silicon germanium layer 104 is formed on a predetermined region of a first side of a silicon substrate 102. The first undoped layer 106 is formed on the first silicon germanium layer 104. The optical waveguide 140 having a core layer 110 surrounded by the first and second clad layers 108 and 112 is formed on the first undoped layer 106. The optical detector 150 is made by subsequently forming the second undoped layer 120 and the second silicon germanium layer 122 on a predetermined region of the exposed core layer 110 of the optical waveguide 140.

In addition, the optical device 100 further includes an n-type electrode 116 and a p-type electrode 118. The n-type electrode 116 is formed on a predetermined region of a second side of the silicon substrate 102 such that the n-type electrode 116 may be connected electrically to the optical detector 150. The p-type electrode 118 is formed on a predetermined region of the second silicon germanium layer 122 such that the p-type electrode 118 may be connected electrically to the optical detector 150.

According to a first embodiment of the present invention, the optical device 100 receives an optical signal from the outside, transmits the received optical signal to the second undoped layer 120 of the optical detector 150 through a core layer 110 of the optical waveguide 140. The second undoped layer 120 absorbs the transmitted optical signal and converts the absorbed optical signal into electron-hole pairs to output the converted signal through the electrodes 116 and 118 as an electric signal.

According to a preferred embodiment of the present invention, the optical waveguide 140 includes a core layer 110 and first and second clad layers 108 and 112. The core layer 110 is located at the center of the optical waveguide 140 and has a relatively larger refractive index. The first and second clad layers 108 and 112 surround the core layer 110 and have relatively small refractive index. Accordingly, light is propagated to the core layer 110 due to its total reflection phenomenon. Herein, only the light satisfying a specific condition can be propagated among the used lights of various wavelengths. The specific light satisfying the condition is called mode. In general, since a single mode optical fiber is used for transferring a signal from the outside, it is preferable that the optical waveguide 140 is also designed to enable a single mode transfer.

In the meanwhile, it is desired that the optical waveguide 140 is formed to have large refractive index difference between the core layer 110 and the first and second clad layer 108 and 112. It is the reason is as follows. Since the size of a mode gets smaller as the refractive index difference between the core layer 110 and the first and second clad layers 108 and 112 gets larger, it is possible to design the core layer 110 having a small cross-sectional area. Since the loss at a bent region is so small that the bending radius can be made small. Consequently, the device can be made small in size.

In a preferred embodiment of the present invention, the core layer 110 is made of silicon nitride (Si₃N₄) of refractive index of about 2, and the first and second clad layers 108 and 112 are made of silicon dioxide (SiO₂) of refractive index of about 1.5. In this case, since the refractive index difference is 30 % or more, it is possible to make the size of the core layer 110 under some micrometers.

Meanwhile, in the optical detector 150, the light transmitted from the optical waveguide 140 is absorbed by the first and second undoped layers 106 and 120. Herein, in order to enable light absorption, the bandgap of the first and second undoped layers 106 and 120 should be smaller than the bandgap of the used wavelength. Accordingly, the available material is limited.

In more detailed description, in order to absorb the light within a wavelength band of 1.3 µm - 1.5 µm used in an optical communication band, germanium at high ratio (0 ≤ x ≤ 0.4) in a silicon germanium compound (SiₓGe₁₋ₓ) or pure germanium (x = 0) is used. In the case of pure germanium, since lattice mismatch with silicon is larger than 4 %, if germanium is directly grown on a silicon layer, defect density is too high to make crystalline growth of high quality. Accordingly, it is desired that a silicon germanium buffer layer (104) is provided on the silicon substrate (102).

According to a variant the first silicon germanium layer 104 and/or the first undoped layer 106 and/or the second undoped layer 120 are silicon germanium layers (SiₓGe₁₋ₓ) with a gradient composition. In case the first silicon germanium layer 104 has a gradient composition, the composition at the interface towards the first undoped layer 106 is essentially equal to the composition of the first undoped layer 106, with the Ge content increasing towards the core layer 110. Thus, in a region close to the core layer 110 the germanium ratio is high (0 ≤ x ≤ 0.4) or even 1 (x = 0). In the case of a gradient first undoped layer 106, the composition at the interface to the first silicon germanium layer 104 is essentially equal to the composition of this one.

In general, it is the most important that high optical coupling efficiency is achieved with a simple configuration in integrating the optical waveguide 140 and the optical detector 150. In other words, the loss of light transmitted to the optical detector 150 through the optical waveguide 140 should be minimized.

According to a preferred embodiment of the present invention, since the core layer 110 of the optical waveguide 140 is employed in the optical detector 150, reflection loss can be eliminated at the coupling portions of the optical waveguide 140 and the optical detector 150. Since additional process or device to change direction of the light of the optical waveguide 140 toward the optical detector 150 is not necessary, high optical coupling efficiency can be simply obtained.

FIGS. 4A through 4H are cross-sectional views to illustrate a method of manufacturing an optical device including an optical waveguide and an optical detector integrally embodied according to a preferred embodiment of the present invention.

First, referring to FIG. 4a, an impurity doped first silicon germanium layer 104 is grown on a silicon substrate 102. According to a preferred embodiment of the present invention, an n-type doped silicon wafer is used as the silicon substrate 102. Accordingly, the case that n-type impurity is doped into a first silicon germanium layer 104 will be described but the basic principle of the case of p-type doped silicon substrate is also the same excepting that p-type and n-type are exchanged for each other.

Herein, in order to easily grow the silicon germanium compound to be used as first undoped layer 106, such that it contains a lot of germanium or pure germanium, the first silicon germanium layer (104) is grown with a gradually growing germanium composition, starting from the substrate 102, in other words, while x in SiₓGe₁₋ₓ goes gradually from 1 to the composition value of the first undoped layer (106), it is desirable to grow the silicon germanium compound.

Sequentially, the first undoped layer 106 made of silicon germanium compound containing a lot of germanium (0 ≤ x ≤ 0.4) or pure germanium (x = 0) is grown on the first silicon germanium layer 104.

Then, a first clad layer 108 is formed on the first undoped layer 106 with a predetermined thickness using the chemical vapor deposition (CVD). Although the first silicon germanium layer 104 and the first undoped layer 106 are grown on the silicon substrate to be used to form the optical detector 150 in the preferred embodiment of the present invention, the optical detector can be formed using the material which can be grown in single crystalline growth on the substrate made of InP or GaAs. If the substrate is made of InP, single crystalline growth layer made of InₓGa₁₋ₓAs can be used.

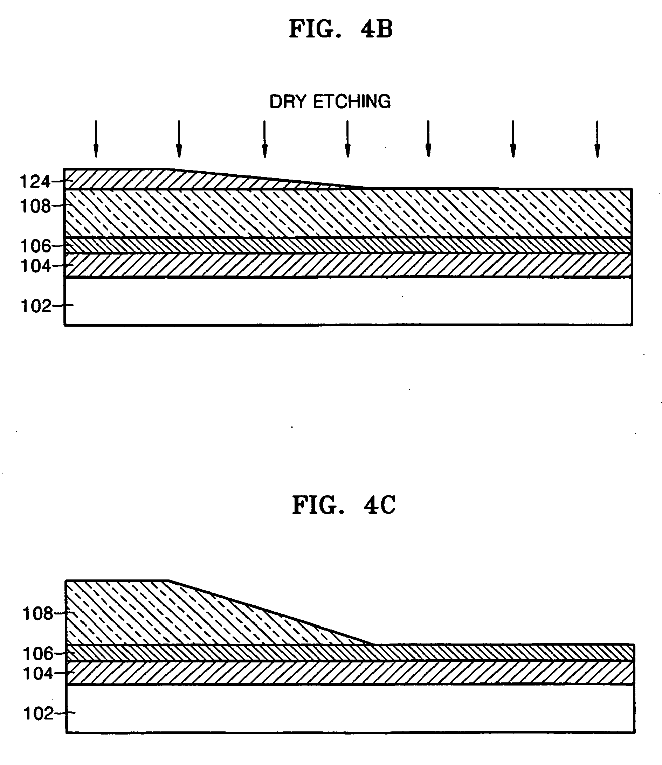

Then, referring to FIGS. 4B and 4C, a first photoresist layer 124 that is sloped and has non-uniform height is formed on the first clad layer 108 using photo lithography process in which gray scale mask is used. Then, dry etching is performed on the first photoresist layer 124 so that the sloped first clad layer 108 is obtained.

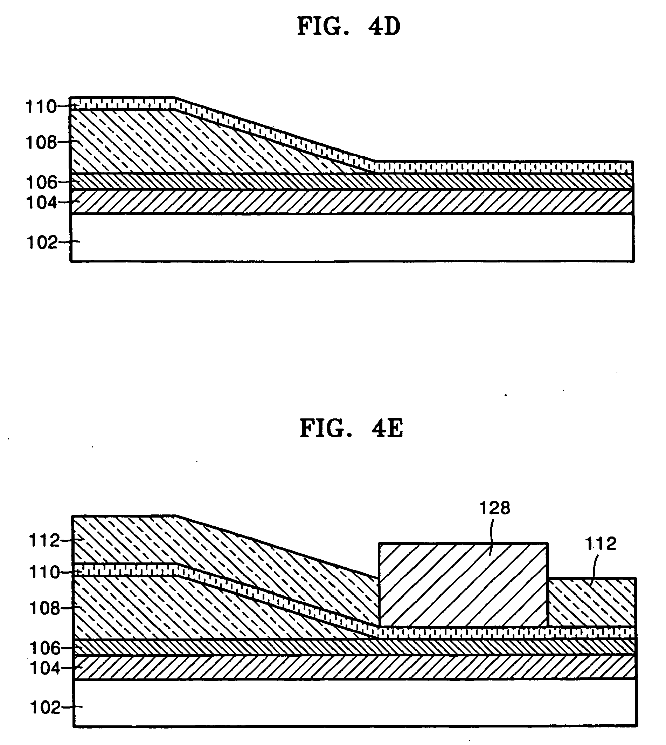

Then, referring to FIG. 4D, the material to be used as the core layer 110 is deposited on the sloped first clad layer 108 and a portion the undoped layer 106 that is not covered by the first clad layer 108. Then, only the core layer 110 having a specific cross-sectional area is remained and the other portions are removed through photolithography and an etching process. According to the preferred embodiment of the present invention, the core layer 110 made of Si₃Nₐ is deposited. The cross-section of the core layer has width of about 0.3 µm and height of about 0.3 µm.

Then, referring to FIG. 4E, after a second photoresist layer 128 is formed using photolithography only on a region in which the optical detector will be formed, the second clad layer 112 is formed in a method such as sputtering. After a second photoresist layer 128 on the optical detector region is removed, the surface of the first undoped layer 106 excepting the core layer 110 of the optical waveguide 140 is treated with chemical reaction so that the following crystalline growth becomes easy.

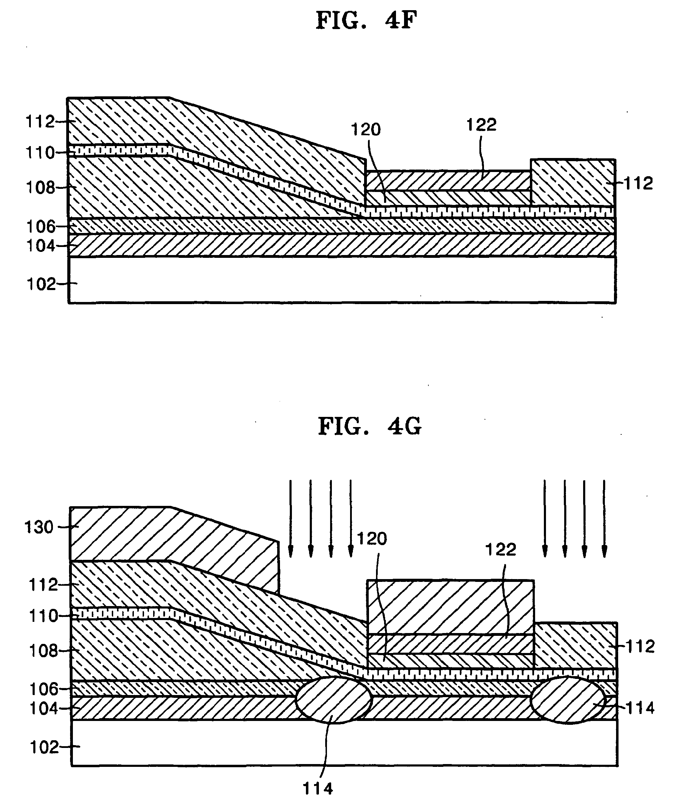

Next, referring to FIG. 4F, after the second undoped layer 120 is grown on the optical detector region, a second silicon germanium layer 122 is sequentially formed. In the preferred embodiment of the present invention, the second undoped layer 120 is made of the identical material to that of the first undoped layer 106, wherein, however, in the variant of a gradient composition (SiₓGe₁₋ₓ) the composition parameter x gradually goes from 0 to 1 or to the composition of the second silicon germanium layer 122 starting from the core layer 110, and the second silicon germanium layer 122 is made of p-type impurity doped silicon germanium.

Then, referring to FIG. 4G, in order to ensure electrical insulation of the optical detection 150, a third photoresist layer 130 is formed as a passivation layer on the entire region excepting circumference portion of the optical detector. The electric insulating layer 114 is formed using ion implantation. The electrical insulating layer 114 helps the optical detector 150 to efficiently operate by enabling the second undoped layer 120 to absorb the light signal transferred through the core layer 110 of the optical waveguide 140 and to convert the light signal into electron-hole pairs, and then by confining the electron-hole pairs in the region of the optical detector 150.

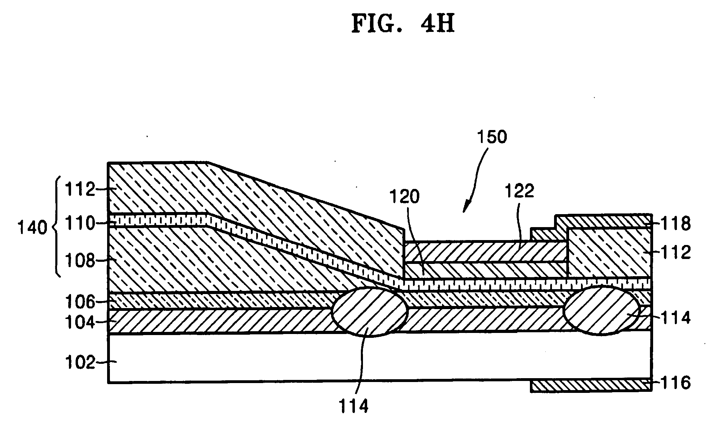

Finally, referring to FIG. 4H, after the third photoresist layer 130 is removed, a p-type electrode 118 and an n-type electrode 116 are formed. The p-type electrode 118 is formed on a predetermined region of the second silicon germanium layer 122 and electrically connected to the outside. The n-type electrode 116 is formed on a predetermined region of a second side of the silicon substrate and electrically connected to the outside.

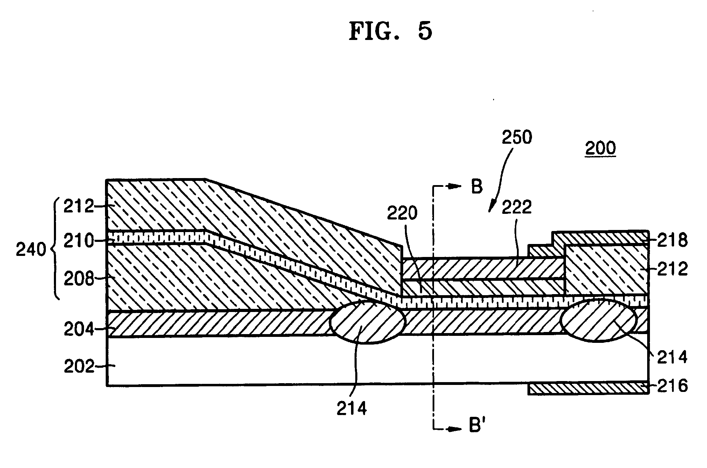

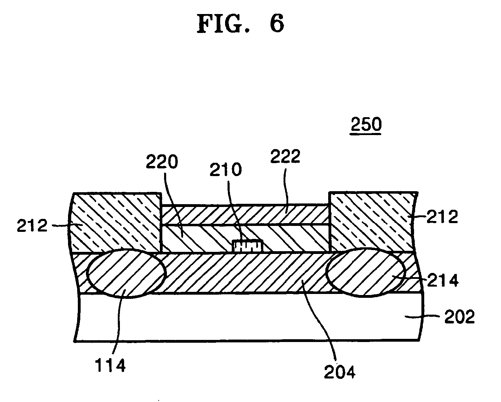

FIG. 5 is a cross-sectional view of an optical device including an optical waveguide and an optical detector integrally embodied according to an example not according to the present invention bad useful for the understanding. FIG. 6 is a cross-sectional view of an optical device taken along the line B-B' in FIG. 5.

The example not according to the present invention is different from the first embodiment in that an optical detector employs only a second undoped layer 120 without a layer as the first undoped layer 106 of the first embodiment.

In more detailed description, there is no undoped layer for absorbing light under a core layer 210 of the light waveguide 240 and an undoped layer 220 is grown only on the portion surrounding the core layer 210 of the light waveguide 230 in the optical detector 250.

In the method of manufacturing an optical device 200 according to the example not according to the present invention, a first clad layer 208 is formed on a first silicon germanium layer 204 which can have a gradient composition like in the first embodiment, in the optical waveguide 240 without a process for growing a first undoped layer 106. A core layer 210 is directly formed on a first silicon germanium layer 204 in the optical detector 250. Other processes are the substantially same as the first embodiment of the present invention shown in FIGs. 4A to 4H.

In the first embodiment of the present invention, the first and second undoped layers 106 and 120 are provided on and under the core layer 110 of the optical waveguide 140 respectively. The first embodiment has an advantage of absorbing most of the lights transmitted to the core layer 110 of the optical waveguide 140.

In the example not according to the present invention, an undoped layer 220 is grown on the optical detector 250 after an optical waveguide 240 is manufactured so that unnecessary defect is prevented from being made on the undoped layer 220. As a result, compared with the first embodiment of the present invention, in the example not according to the present invention, since it is possible to absorb sufficient light amount to detect an optical signal by continuously grow the undoped layer 220 without any defects, it is effective that the optoelectric conversion of the optical detector 250 is improved.

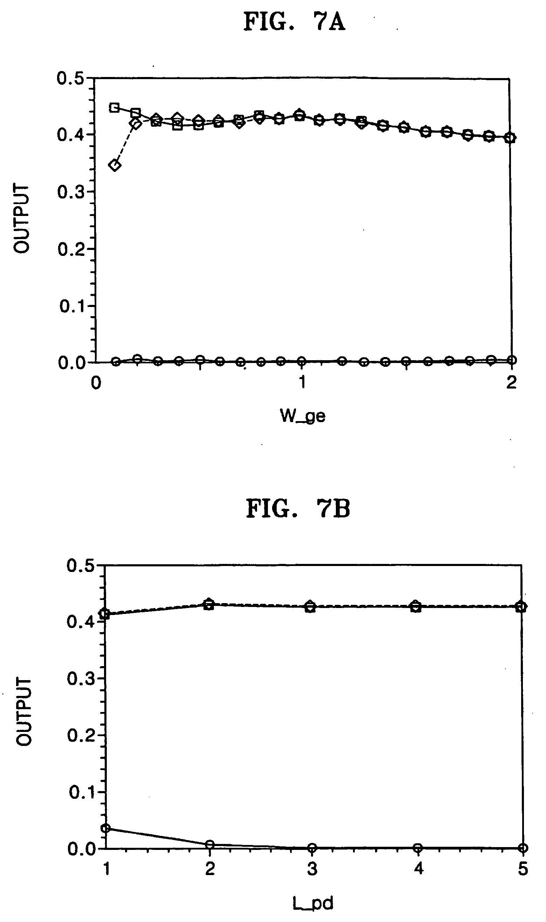

FIGS. 7A through 7B are graphs to illustrate a simulation result representing the amount of light absorbed by the optical detector from the optical waveguide in the optical device including the optical waveguide and the optical detector integrally.

In FIG. 7A, x-axis represents the thickness of the undoped layer and y-axis represents a monitor output. □ represents the light amount absorbed by the second undoped layer 120, ◇ represents the light amount absorbed by the first undoped layer 106, and ○ represents the reflected light amount. As shown in the graph, if the first and second undoped layers are thick 0.2 µm or more, the first and second undoped layers can absorb the light by 40 % or more. Thus, 80 % or more light absorption is possible entirely.

In FIG. 7B, x-axis represents the length of the undoped layer and y-axis represents a monitor output. □ represents the light amount absorbed by the second undoped layer 120, ◇ represents the light amount absorbed by the first undoped layer 106, and ○ represents the reflected light amount. As shown in the graph, if the length of the first and second undoped layers are 2 µm or more, the first and second undoped layers can absorb the light by 40 % or more. Thus, 80 % or more light absorption is possible entirely.

According to the preferred embodiment of the present invention, the optical waveguide and the optical detector are integrally included so that additional processes such as an alignment process and a flip-chip boding are not necessary and the production cost of the optical device can be saved.

According to the preferred embodiment of the present invention, the optical waveguide and the optical detector are not shorted but the core of the optical waveguide is employed as itself in the optical detector so that the manufacture process is simple and optical coupling efficiency can be improved.

According to the preferred embodiment of the present invention, since cheap single material of silicon family and the existing large silicon wafer production process can be used, the optical transceiver can be innovatively lowered in price.

Since the method of manufacturing the present invention can be easily expanded and adopted for additional coupling the optical device, complex device can be manufactured using monolithic integration of the optical device at a low cost.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An optical device for an optical communication network for detecting an optical signal comprising:
a substrate (102, 202);
an optical waveguide (140) provided with clad layers (108, 112) surrounding a core layer (110), for guiding the optical signal;
an optical detector (150) comprising a light absorption region, for detecting the optical signal;
an n-type electrode (116) formed on a side of the substrate (102); and
a p-type electrode (118) connected electrically to the optical detector (150),
**characterized in that**
the light absorption region of the optical detector (150) comprises a first and second light absorption layer provided adjacent to and on and under the core layer (110) of a predetermined portion of the optical waveguide (140) where a portion of the clad layers has been removed respectively.

2. The optical device of claim 1, wherein the first and second absorption layers (106, 120) are a first and second undoped layer (106, 120).

3. An optical device according to claim 1 to 2 further comprising:
a first single crystalline growth layer (104) grown on the substrate (102);
wherein the optical waveguide (140) is formed over the first single crystalline growth layer (104); and
wherein the optical detector (150) comprises
a second single crystalline growth layer (122) grown on the second undoped layer (120).

4. The optical device of claim 3, further comprising an insulating layer (114) formed near to the exposed core layer (110, 210) in the first single crystalline growth layer (104).

5. The optical device of claims 3 or 4, wherein, the substrate (102) is made of silicon, and the first single crystalline growth layer (104) and the second single crystalline growth layer (122, 222) are silicon germanium layers.

6. The optical device according to one of claims 3 to 5, wherein the first and second undoped layer (106, 120), is made of a silicon germanium compound (SiₓGe₁₋ₓ), where x gradually goes from a value of 0 ≤ x ≤ 0.4 to 1 as it goes further from the core layer (110) so that a portion near to the core layer (110) consists of a silicon germanium compound whose germanium ratio is high (0 ≤ x ≤ 0.4) or pure germanium (x = 0).

7. The optical device of one of claims 1 to 6, wherein the substrate (102) is made of InP and the single crystalline growth layers (104, 122) are made of InₓGa₁₋ₓAs.

8. The optical device according to one of claims 3 to 6, wherein furthermore the first single crystalline growth layer (104) is a silicon germanium buffer layer and the additional undoped layer (106) is a silicon germanium compound (SiₓGe₁₋ₓ) with a high germanium composition ratio, in particular with 0 ≤ x ≤ 0.4, or pure germanium (x = 0).

9. The optical device according to claim 8, wherein the first single crystalline growth layer (104) is made of a silicon germanium compound (SiₓGe₁₋ₓ) where starting from the substrate (102) x gradually goes from 1 to the x corresponding to the composition of the additional undoped layer (106).

10. The optical device according to one of claims 3 to 6, wherein the first single crystalline growth layer (104) is a silicon germanium buffer layer; and
wherein the additional undoped layer (106) is made of a silicon germanium compound (SiₓGe₁₋ₓ), where x gradually goes from the x corresponding to the composition of the first single crystalline growth layer (104) to 0 ≤ x ≤ 0.4 as it goes further from the substrate (102) so that the portion near to the core layer (110) consists of a silicon germanium compound whose germanium ratio is high (0 ≤ x ≤ 0.4) or pure germanium (x = 0).

11. The optical device of claims 1 to 10, wherein the core layer (110) is made of silicon nitride or silicon and the clad layer (108, 112) is made of silicon dioxide.

12. A method of manufacturing an optical device for detecting an optical signal, comprising the steps:
a) growing a first single crystalline growth layer (104) on a substrate (102);
a2) forming a first light absorption layer (106);
b) forming a first clad layer (108) over the first single crystalline growth layer (104);
c) patterning the first clad layer (108) so as to make the first clad layer (108) sloped and exposing a part of the first light absorption layer (106);
d) forming a core layer (110) on the patterned first clad layer (108) and the exposed first light absorption layer (106);
e) forming a second single clad layer (112) on the core layer (110);
f) exposing a predetermined region of the core layer (110) by patterning the second clad layer (112) in a predetermined shape;
g) forming of a second light absorption layer (120) on the exposed core layer (110); and
h) forming a second single crystalline growth layer (122) over the exposed core layer (110);
i) forming and n-type electrode (116) on a side of the substrate (102); and
j) forming a p-type electrode (118) on the second single crystalline growth layer (122).

13. The method according to claim 12, wherein the first and second absorption layers (106, 120) are frist and second undoped layers (106, 120) respectively.

14. The method of claim 12 or 13, further comprising:
forming an insulating layer (114) by implanting ions into the first single crystalline growth layer (104) positioned under peripheral portions of the second single crystalline growth layer (122).

15. The method according to claim 12 or 13, wherein the second undoped layer (120) is made of a silicon germanium compound (SiₓGe₁₋ₓ) which is formed such that x goes gradually from 0 ≤ x ≤ 0.4 to 1 as it grows further from the core layer (110) so that a portion near to the core layer (110) consists of a silicon germanium compound whose germanium ratio is high (0 ≤ x ≤ 0.4) or pure germanium (x = 0).

16. The method according to claim 12 or 13, wherein the second undoped layer (120) is grown such that it is a silicon germanium compound whose germanium ratio is high (0 ≤ x ≤ 0.4) or pure germanium (x = 0).

17. The method according to claim 12 or 13 wherein the first single crystalline growth layer (104) is a silicon germanium buffer layer and wherein the first undoped layer (106) is a silicon germanium compound (SiₓGe₁₋ₓ), which is formed such that x gradually goes from the x corresponding to the composition of the first single crystalline growth layer (104) to 0 ≤ x ≤ 0.4 as it goes further from the substrate (102) so that a portion near to the core layer (110) consists of a silicon germanium compound whose germanium ratio is high (0 ≤ x ≤ 0.4) or pure germanium (x = 0).

18. The method according to claim 12 or 13, wherein the first single crystalline growth layer (104) is a silicon germanium buffer layer, and wherein the first undoped layer (106) is grown such that it is a silicon germanium compound (SiₓGe₁₋ₓ)whose germanium ratio is high (0 ≤ x ≤ 0.4) or pure germanium (x = 0).

19. The method according to claim 18, wherein the first single crystalline growth layer (104) is made of a silicon germanium compound (SiₓGe₁₋ₓ) which is formed such that x goes gradually from 1 to the x corresponding to the composition of the silicon germanium compound of the first undoped layer (106).

## Patentansprüche

1. Optische Vorrichtung für ein optisches Kommunikationsnetz zum Erfassen eines optischen Signals, die umfasst:
ein Substrat (102, 202);
einen Lichtwellenleiter (140) zum Leiten des optischen Signals, der mit Ummantelungsschichten (108, 112) und einer umgebenden Kernschicht (110) versehen ist;
einen optischen Detektor (150), der einen Lichtabsorptionsbereich zum Erfassen des optischen Signals aufweist;
eine n-leitende Elektrode (116), die an einer Seite des Substrats (102) ausgebildet ist; und
eine p-leitende Elektrode (118), die elektrisch mit dem optischen Detektor (150) verbunden ist,
**dadurch gekennzeichnet, dass**
der Lichtabsorptionsbereich des optischen Detektors (150) eine erste und eine zweite Lichtabsorptionsschicht umfasst, die an die Kernschicht (110) eines vorgegebenen Abschnitts des Lichtwellenleiters (140), in dem ein Abschnitt der Ummantelungsschichten entfernt worden ist, angrenzend, auf und unter ihr vorhanden sind.

2. Optische Vorrichtung nach Anspruch 1, wobei die erste und die zweite Absorptionsschicht (106, 120) eine erste und eine zweite undotierte Schicht (106, 120) sind.

3. Optische Vorrichtung nach Anspruch 1 bis 2, die des Weiteren umfasst:
eine erste Einkristall-Wachstumsschicht (104), die auf das Substrat (102) aufgewachsen ist;
wobei der Lichtwellenleiter (140) über der ersten Einkristall-Wachstumsschicht (104) ausgebildet ist; und
wobei der optische Detektor (150) umfasst:
eine zweite Einkristall-Wachstumsschicht (122), die auf die zweite undotierte Schicht (120) aufgewachsen ist.

4. Optische Vorrichtung nach Anspruch 3, die des Weiteren eine isolierende Schicht (114) umfasst, die nahe der freigelegten Kernschicht (110, 210) in der ersten Einkristall-Wachstumsschicht (104) ausgebildet ist.

5. Optische Vorrichtung nach den Ansprüchen 3 oder 4, wobei das Substrat (102) aus Silizium besteht und die erste Einkristall-Wachstumsschicht (104) sowie die zweite Einkristall-Wachstumsschicht (122, 222) Silizium-Germanium-Schichten sind.

6. Optische Vorrichtung nach einem der Ansprüche 3 bis 5, wobei die erste und die zweite undotierte Schicht (106, 120) aus einer Silizium-Germanium-Verbindung (SiₓGe₁₋ₓ) bestehen und x mit zunehmender Entfernung zu der Kemschicht (110) allmählich von einem Wert 0 ≤ x ≤ 0,4 auf 1 ansteigt, so dass sich ein Abschnitt nahe der Kemschicht (110) aus einer Silizium-Germanium-Verbindung mit hohem Germanium-Anteil (0 ≤ x ≤ 0,4) oder aus reinem Germanium (x = 0) zusammensetzt.

7. Optische Vorrichtung nach einem der Ansprüche 1 bis 6, wobei das Substrat (102) aus InP besteht und die Einkristall-Wachstumsschichten (104, 122) aus InₓGa₁₋ₓAs bestehen.

8. Optische Vorrichtung nach einem der Ansprüche 3 bis 6, wobei des Weiteren die erste Einkristall-Wachstumsschicht (104) eine Silizium-Germanium-Pufferschicht ist und die zusätzliche undotierte Schicht (106) eine Silizium-Germanium-Verbindung (SiₓGe₁₋ₓ) mit einem hohen Germanium-Zusammensetzungsanteil, d.h. 0 ≤ x ≤ 0,4, oder reines Germanium (x = 0) ist.

9. Optische Vorrichtung nach Anspruch 8, wobei die erste Einkristall-Wachstumsschicht (104) aus einer Silizium-Germanium-Verbindung (SiₓGe₁₋ₓ) besteht, und von dem Substrat (102) aus sich x allmählich von 1 zu dem x entwickelt, das der Zusammensetzung der zusätzlichen undotierten Schicht (106) entspricht.

10. Optische Vorrichtung nach einem der Ansprüche 3 bis 6, wobei die erste Einkristall-Wachstumsschicht (104) eine Silizium-Germanium-Pufferschicht ist; und
wobei die zusätzliche undotierte Schicht (106) aus einer Silizium-Germanium-Verbindung (SiₓGe₁₋ₓ) besteht, sich x mit zunehmender Entfernung zu dem Substrat (102) allmählich von dem x, das der Zusammensetzung der ersten Einkristall-Wachstumsschicht (104) entspricht, zu 0 ≤ x ≤ 0,4 entwickelt, so dass sich der Abschnitt nahe der Kemschicht (110) aus einer Silizium-Germanium-Verbindung mit hohem Germanium-Anteil (0 ≤ x ≤ 0,4) oder reinem Germanium (x = 0) zusammensetzt.

11. Optische Vorrichtung nach den Ansprüchen 1 bis 10, wobei die Kernschicht (110) aus Siliziumnitrid oder Silizium besteht und die Ummantelungsschicht (108, 112) aus Siliziumdioxid besteht.

12. Verfahren zum Herstellen einer optischen Vorrichtung zum Erfassen eines optischen Signals, das die folgende Schritte umfasst:
a) Aufwachsen einer ersten Einkristall-Wachstumsschicht (104) auf einem Substrat (102);
a2) Ausbilden einer ersten Lichtabsorptionsschicht (106);
b) Ausbilden einer ersten Ummantelungsschicht (108) über der ersten Einkristall-Wachstumsschicht (104);
c) Strukturieren der ersten Ummantelungsschicht (108), so dass die erste Ummantelungsschicht (108) abgeschrägt wird und ein Teil der ersten Lichtabsorptionsschicht (106) freigelegt wird;
d) Ausbilden einer Kernschicht (110) auf der strukturierten ersten Ummantelungsschicht (108) und der freigelegten ersten Lichtabsorptionsschicht (106);
e) Ausbilden einer zweiten einzelnen Ummantelungsschicht (112) auf der Kernschicht (110);
f) Freilegen eines vorgegebenen Bereiches der Kernschicht (110) durch Strukturieren der zweiten Ummantelungsschicht (112) in einer vorgegebenen Form;
g) Ausbilden einer zweiten Lichtabsorptionsschicht (120) auf der freigelegten Kernschicht (110); und
h) Ausbilden einer zweiten Einkristall-Wachstumsschicht (122) über der freigelegten Kernschicht (110);
i) Ausbilden einer n-leitenden Elektrode (116) an einer Seite des Substrats (102); und
j) Ausbilden einer p-leitenden Elektrode (118) an der zweiten Einkristall-Wachstumsschicht (122).

13. Verfahren nach Anspruch 12, wobei die erste und die zweite Absorptionsschicht (106, 120) eine erste bzw. zweite undotierte Schicht (106, 120) sind.

14. Verfahren nach Anspruch 12 oder 13, das des Weiteren umfasst:
Ausbilden einer isolierenden Schicht (114) durch Implantieren von Ionen in die erste Einkristall-Wachstumsschicht (104), die unter Randabschnitten der zweiten Einkristall-Wachstumsschicht (122) positioniert ist.

15. Verfahren nach Anspruch 12 oder 13, wobei die zweite undotierte Schicht (120) aus einer Silizium-Germanium-Verbindung (SiₓGe₁₋ₓ) besteht, die so ausgebildet wird, dass x mit zunehmender Entfernung zu der Kernschicht (110) allmählich von 0 ≤ x ≤ 0,4 auf 1 ansteigt, so dass sich ein Abschnitt nahe der Kernschicht (110) aus einer Silizium-Germanium-Verbindung mit hohem Germanium-Anteil (0 ≤ x ≤ 0,4) oder aus reinem Germanium (x = 0) zusammensetzt.

16. Verfahren nach Anspruch 12 oder 13, wobei die zweite undotierte Schicht (120) so aufgewachsen wird, dass sie eine Silizium-Germanium-Verbindung mit hohem Germanium-Anteil (0 ≤ x ≤ 0,4) oder reines Germanium (x = 0) ist.

17. Verfahren nach Anspruch 12 oder 13, wobei die erste Einkristall-Wachstumsschicht (104) eine Silizium-Germanium-Pufferschicht ist und die erste undotierte Schicht (106) eine Silizium-Germanium-Verbindung (SiₓGe₁₋ₓ) ist, die so ausgebildet wird, dass sich x mit zunehmender Entfernung zu dem Substrat (102) allmählich von dem x, das der Zusammensetzung der ersten Einkristall-Wachstumsschicht (104) entspricht, zu 0 ≤ x ≤ 0,4 entwickelt, so dass sich ein Abschnitt nahe der Kemschicht (110) aus einer Silizium-Germanium-Verbindung mit hohem Germanium-Anteil (0 ≤ x ≤ 0,4) oder reinem Germanium (x = 0) zusammensetzt.

18. Verfahren nach Anspruch 12 oder 13, wobei die erste Einkristall-Wachstumsschicht (104) eine Silizium-Germanium-Pufferschicht ist und die erste undotierte Schicht (106) so aufgewachsen wird, dass sie eine Silizium-Germanium-Verbindung (SiₓGe₁₋ₓ) mit hohem Germanium-Anteil (0 ≤ x ≤ 0,4) oder reines Germanium (x = 0) ist.

19. Verfahren nach Anspruch 18, wobei die erste Einkristall-Wachstumsschicht (104) aus einer Silizium-Germanium-Verbindung (SiₓGe₁₋ₓ) besteht, die so ausgebildet wird, dass sich x allmählich von 1 zu dem x entwickelt, das der Zusammensetzung der Silizium-Germanium-Verbindung der ersten undotierten Schicht (106) entspricht.

## Revendications

1. Dispositif optique pour un réseau de communication optique destiné à détecter un signal optique comprenant :
un substrat (102, 202) :
un guide d'onde optique (140) pourvu de couches de revêtement (108, 112) entourant une couche de coeur (110), pour guider le signal optique ;
un détecteur optique (150) comprenant une région d'absorption de lumière, pour détecter le signal optique ;
une électrode de type n (116) formée sur un côté du substrat (102) ; et
une électrode de type p (118) connectée électriquement au détecteur optique (150),
**caractérisé en ce que**
la région d'absorption de lumière du détecteur optique (150) comprend des première et seconde couches d'absorption de lumière disposées adjacentes à et sur et sous la couche de coeur (110) d'une portion prédéterminée du guide d'onde optique (140) où une portion des couches de revêtement a été enlevée, respectivement.

2. Dispositif optique selon la revendication 1, dans lequel les première et seconde couches d'absorption (106, 120) sont de première et seconde couches non dopées (106, 120).

3. Dispositif optique selon la revendication 1 ou 2, comprenant en outre :
une première couche de croissance monocristalline (104) formée sur le substrat (102) ;
dans lequel le guide onde optique (140) est formé sur la première couche de croissance monocristalline (104) ; et
dans lequel le détecteur optique (150) comprend
une seconde couche de croissance monocristalline (122) formée sur la seconde couche non dopée (120).

4. Dispositif optique selon la revendication 3, comprenant en outre une couche isolante (114) formée près de la couche de coeur exposée (110, 210) dans la première couche de croissance monocristalline (104).

5. Dispositif optique selon les revendications 3 ou 4, dans lequel le substrat (102) est constitué de silicium, et la première couche de croissance monocristalline (104) et la seconde couche de croissance monocristalline (122, 222) sont des couches en silicium-germanium.

6. Dispositif optique selon l'une quelconque des revendications 3 à 5, dans lequel les première et seconde couches non dopées (106, 120) sont constituées d'un composé de silicium-germanium (SiₓGe₁₋ₓ), où x varie progressivement d'une valeur de 0 ≤ x ≤ 0,4 à 1 à mesure qu'il s'éloigne de la couche de coeur (110) de sorte qu'une portion près de la couche de coeur (110) consiste en un composé de silicium-germanium dont la proportion de germanium est élevée (0 ≤ x ≤ 0,4) ou en du germanium pur (x = 0).

7. Dispositif optique selon l'une quelconque des revendications 1 à 6, dans lequel le substrat (102) est constitué de InP et les couches de croissance monocristalline (104, 122) sont constituées de InₓGa₁₋ₓAs.

8. Dispositif optique selon l'une quelconque des revendications 3 à 6, dans lequel, de plus, la première couche de croissance monocristalline (104) est une couche tampon de silicium-germanium et la couche non dopée additionnelle (106) est un composé de silicium-germanium (SiₓGe₁₋ₓ) avec un rapport de composition de germanium élevé, en particulier avec 0 ≤ x ≤ 0,4 ou du germanium pur (x = 0).

9. Dispositif optique selon la revendication 8, dans lequel la première couche de croissance monocristalline (104) est constituée d'un composé de silicium-germanium (SiₓGe₁₋ₓ) où en commençant à partir du substrat (102), x varie progressivement de 1 au x correspondant à la composition de la couche non dopée additionnelle (106).

10. Dispositif optique selon l'une quelconque des revendications 3 à 6, dans lequel la première couche de croissance monocristalline (104) est une couche tampon de silicium-germanium ; et
dans lequel la couche non dopée additionnelle (106) est constituée d'un composé de silicium-germanium (SiₓGe₁₋ₓ), où x varie progressivement du x correspondant à la composition de la première couche de croissance monocristalline (104) à 0 ≤ x ≤ 0,4 à mesure qu'il s'éloigne du substrat (102) de sorte que la portion près de la couche de coeur (110) consiste en un composé de silicium-germanium dont la proportion de germanium est élevée (0 ≤ x ≤ 0,4) ou du germanium pur (x = 0).

11. Dispositif optique selon les revendications 1 à 10, dans lequel la couche de coeur (110) est constituée de nitrure de silicium ou de silicium et la couche de revêtement (108, 112) est constituée de dioxyde de silicium.

12. Procédé de fabrication d'un dispositif optique destiné à détecter un signal optique, comprenant les étapes consistant à :
a) former une première couche de croissance monocristalline (104) sur un substrat (102) ;
a2) former une première couche d'absorption de lumière (106) ;
b) former une première couche de revêtement (108) au-dessus la première couche de croissance monocristalline (104) ;
c) modeler la première couche de revêtement (108) de façon à rendre la première couche de revêtement (108) inclinée et exposer une partie de la première couche d'absorption de lumière (106) ;
d) former une couche de coeur (110) sur la première couche de revêtement (108) modelée et la première couche d'absorption de lumière (106) exposée ;
e) former une seconde couche de revêtement (112) sur la couche de coeur (110) ;
f) exposer une région prédéterminée de la couche de coeur (110) en modelant la seconde couche de revêtement (112) en une forme prédéterminée ;
g) former une seconde couche d'absorption de lumière (120) sur la couche de coeur exposée (110) ; et
h) former une seconde couche de croissance monocristalline (122) sur la couche de coeur exposée (110) ;
i) former une électrode de type n (116) sur un côté du substrat (102) ; et
j) former une électrode de type p (118) sur la seconde couche de croissance monocristalline (122).

13. Procédé selon la revendication 12, dans lequel les première et seconde couches d'absorption (106, 120) sont des première et seconde couches non dopées (106, 120) respectivement.

14. Procédé selon la revendication 12 ou 13, comprenant en outre l'étape consistant à :
former une couche isolante (114) en implantant des ions dans la première couche de croissance monocristalline (104) positionnée sous des portions périphériques de la seconde couche de croissance monocristalline (122).

15. Procédé selon la revendication 12 ou 13, dans lequel la seconde couche non dopée (120) est constituée d'un composé de silicium-germanium (SiₓGe₁₋ₓ) qui est formé de telle sorte que x varie progressivement de 0 ≤ x ≤ 0,4 à 1 à mesure qu'il s'éloigne de la couche de coeur (110) de sorte qu'une portion près de la couche de coeur (110) consiste en un composé de silicium-germanium dont la proportion de germanium est élevée (0 ≤ x ≤ 0,4) ou du germanium pur (x = 0).

16. Procédé selon la revendication 12 ou 13, dans lequel la seconde couche non dopée (120) est formée de telle sorte qu'elle est un composé de silicium-germanium dont la proportion de germanium est élevée (0 ≤ x ≤ 0,4) ou du germanium pur (x = 0).

17. Procédé selon la revendication 12 ou 13, dans lequel la première couche de croissance monocristalline (104) est une couche tampon de silicium-germanium et dans lequel la première couche non dopée (106) est un composé de silicium-germanium (SiₓGe₁₋ₓ), qui est formée de telle sorte que x varie progressivement du x correspondant à la composition de la première couche de croissance monocristalline (104) à 0 ≤ x ≤ 0,4 à mesure qu'il s'éloigne du substrat (102) de sorte qu'une portion près de la couche de coeur (110) consiste en un composé de silicium-germanium dont la proportion de germanium est élevée (0 ≤ x ≤ 0,4) ou du germanium pur (x = 0).

18. Procédé selon la revendication 12 ou 13, dans lequel la première couche de croissance monocristalline (104) est une couche tampon de silicium-germanium, et dans lequel la première couche non dopée (106) est formée de telle sorte qu'elle est un composé de silicium-germanium (SiₓGe₁₋ₓ) dont la proportion de germanium est élevée (0 ≤ x ≤ 0,4) ou du germanium pur (x = 0).

19. Procédé selon la revendication 18, dans lequel la première couche de croissance monocristalline (104) est constituée d'un composé de silicium-germanium (SiₓGe₁₋ₓ) qui est formé de telle sorte que x varie progressivement de 1 au x correspondant à la composition du composé de silicium-germanium de la première couche non dopée (106).
